Europäisches Patentamt

European Patent Office

Office européen des brevets

(11) Publication number: **0 293 970**
**A2**

## EUROPEAN PATENT APPLICATION

(21) Application number: **88201014.3**

(22) Date of filing: **20.05.88**

(51) Int. Cl.⁴: **H01L 23/48**

(30) Priority: **03.06.87 IT 2076687**

(43) Date of publication of application:
**07.12.88 Bulletin 88/49**

(84) Designated Contracting States:
**DE FR GB NL SE**

(71) Applicant: **SGS-THOMSON MICROELECTRONICS S.p.A.**
**Stradale Primosole 50**
**I-95121 Catania (CT)(IT)**

(72) Inventor: **Wragg, Peter**
**Via Nuvolari 12/8**
**I-20020 Arese Milano(IT)**

(74) Representative: **Mittler, Enrico et al**
**c/o Marchi & Mittler s.r.l. Viale Lombardia, 20**
**I-20131 Milano(IT)**

(54) **Pad for supporting a chip of an integrated-circuit electronic component.**

(57) A pad (1) for supporting the chip (6), in which there are openings (7) so that the pad (1) can be deformed easily thus avoiding the forming of tensions at the pad-chip interface.

Fig.1

## "Pad for supporting a chip of an integrated-circuit electronic component."

The present invention refers to a pad for supporting a chip of an integrated-circuit electronic component

As is well known, in the manufacturing phase of an integrated circuit a chip is glued to a pad consisting of a metal plate included in a metal frame. This latter part also includes a plurality of connecting leads to the external contacts, on which are soldered the ends of a plurality of internal leads whose other ends are soldered to the chip.

At the end of such operations, the central part of the frame, together with the chip and the internal leads, are encased in a resin package from which only the contact pins protrude.

During its life the finished product in turn is subjected to temperature changes due to changes in the ambient temperatures and to the heat generated during the chip's operation.

Since the pad's metal and the silicon from which the chip is made have different expansion coefficients, tensions tend to be created at the pad-chip interface which, if sufficiently large, will damage the chip.

In view of this state of the art, the object of the present invention is to accomplish a pad for supporting a chip, in which the tensions produced by the expansion of the pad are substantially reduced, so that no ill effects are produced on the chip.

According to the invention, said object is attained by a pad supporting a chip, characterized in that it has several openings.

Such openings are windows obtained within the pad and/or cuts or notches along its rim.

Preferably such openings are made at the corners of the pad, which are the areas where such tensions are concentrated.

With this arrangement the pad is easily deformed with a consequent reduction in the tensions at the pad-chip interface.

One possible embodiment of the present invention is illustrated as a non-limiting example in the enclosed drawings, in which:

Fig. 1 shows a chip support frame comprising a pad accomplished according to the invention, seen as a plan from the top;

Fig. 2 shows a section along the line II-II of Fig. 1.

With reference to the enclosed figures, a pad 1 for supporting a chip is shown which is part of a metal frame 3 also comprising a plurality of connecting leads 4 for the external contacts, radial connecting elements 2 and a temporary external bezel 8 which which holds together all the elements of the frame 3.

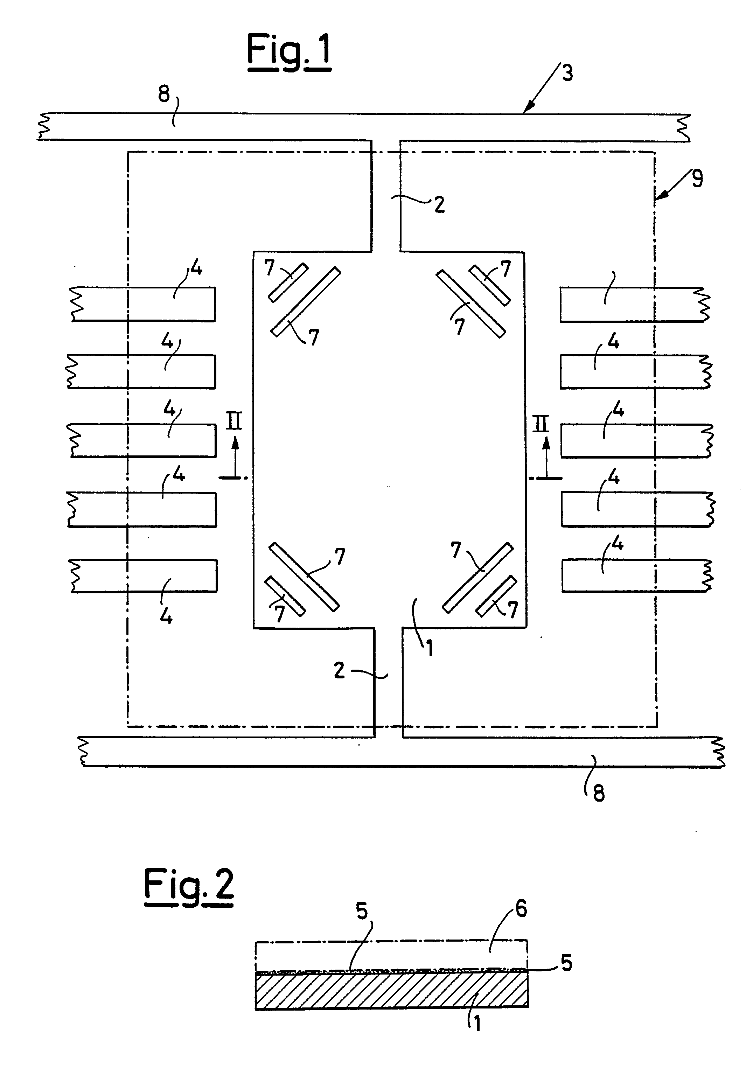

As shown in Fig. 2, a chip 6 is glued, for instance with a layer of glue 5, on to the pad 1.

The chip 6 is subsequently connected electrically to the leads 4 by means of internal leads which may be threadlike or tapelike (not shown).

In a subsequent phase the central part of the frame 3, together with the chip 6 and the internal leads, are encased in a resin container or "package" 9 whose outlines are indicated in Fig. 1 with a dot-and-dash line.

Lastly the bezel 8 is removed by cutting, so that the external leads 4 are kept electrically separate.

As can be seen from Fig. 1, the pad 1 has openings 7 in the corners of the same.

In this particular embodiment the openings 7 have the shape of rectangular windows arranged at an angle of 45° to the adjacent sides of the pad. This arrangement can be modified at will, and different shaped and sized cuts or notches can be made along the sides of the pads.

During the life of the finished product the openings 7 compensate for the greater heat expansion of the pad 1 with respect to the chip 6, so that the tensions at the pad-chip interface are adequately absorbed.

## Claims

1. Pad (6) for supporting a chip of an integrated-circuit electronic component, characterized in that it has openings (7).

2. Pad according to claim 1, characterized in that said openings are windows (7) obtained within said pad.

3. Pad according to claim 1, characterized in that said openings are cuts or notches made on its outer rim.

4. Pad according to any of the previous claims, characterized in that said openings are made at the corners of said pad.

# Fig.1

# Fig.2